# EUROPEAN PATENT APPLICATION

(11) **EP 4 760 323 A1**
(43) Date of publication of application: **17.06.2026**
(21) Application number: 25209838.9
(22) Date of filing: 20.10.2025
(51) Int. Cl.: G01R 31/74, B60L 3/04, H02J 7/60

(54) **FUSE DEVICE, BATTERY MANAGEMENT SYSTEM, AND BATTERY PACK**

(30) Priority: 12.12.2024 KR 20240184491
(71) Applicant: SAMSUNG SDI CO., LTD., Yongin-si, Gyeonggi-do 17084 (KR)
(72) Inventor: CHO, Kyu Sung, 16678 Suwon-si (KR)
(74) Representative: Marks & Clerk LLP

(57) **Abstract**

The present disclosure relates to a fuse device, a battery management system, and a battery pack, and is directed to providing a circuit configuration capable of integrally performing a diagnosis function and an ignition function of a fuse that is is a protective element provided in the battery pack. To this end, a fuse device includes a fuse element, a diagnosis current supply circuit connected to the fuse element can configured to allow a diagnosis current for diagnosing the fuse element to flow through the fuse element, and an ignition circuit connected to the diagnosis current supply circuit and configured to allow an ignition current for ignition of the fuse element to flow through the fuse element. The diagnosis operation and the ignition operation of the fuse element are performed by controlling the activation of the diagnosis current supply circuit and the ignition circuit.

## Description

### BACKGROUND

### 1. Field

The present disclosure relates to a fuse device, a battery management system, and a battery pack.

### 2. Description of the Related Art

A battery pack includes battery cells and peripheral circuits including charge/discharge circuits. A peripheral circuit is manufactured as a printed circuit board and then connected to the battery cell. When an external power source is connected to an external terminal of the battery pack, the battery cells are charged. When a load is connected to the external terminal, the battery cells are discharged. The charge/discharge circuit controls the charging/discharging of the battery cells between the external terminal and the battery cells. Generally, battery cells are connected in series and parallel depending on a consumption capacity of the load.

When an abnormal power supply operation of the battery pack occurs, such as when an overcurrent flows from the battery pack to the load, it is necessary to protect the battery pack, the load, the product to which the battery pack is applied, and the user. To effect such protection, a current path connected to the battery (i.e., a current path connected from the battery cell to the load) is blocked. In particular, a fuse can be used to block the flow of current by physically cutting the current path connected to the battery.

The information disclosed in this section is for enhancement of understanding of the background of the present disclosure. It may contain information that does not constitute related or prior art.

### SUMMARY

The present disclosure is directed to providing a fuse device, a battery management system, and a battery pack capable of performing a diagnosis function and an ignition function of a fuse, which is a protective element provided in the battery pack.

However, objects that the present disclosure achieves are not limited to the above-described objects and other objects that are not described may be clearly understood by those skilled in the art from the following description.

A fuse device according to one embodiment of the present disclosure includes a fuse element configured to block a current path connected to a battery, a diagnosis current supply circuit connected to the fuse element and configured to allow a diagnosis current for diagnosing the fuse element to flow through the fuse element, and an ignition circuit connected to the diagnosis current supply circuit and configured to allow an ignition current for ignition of the fuse element to flow through the fuse element, wherein the diagnosis current supply circuit is configured to form the diagnosis current regardless of whether the ignition circuit is activated, and the ignition circuit is configured to form the ignition current depending on whether the diagnosis current supply circuit is activated.

The ignition circuit may include an ignition switch that is configured to be turned on in response to an input of at least one of first and second ignition signals to form the ignition current in the fuse element, and a first processor is configured to apply the first ignition signal to control the operation of the fuse device, and a second processor is configured to apply the second ignition signal , with the second processor functioning as an upper controller of the first processor.

The diagnosis current supply circuit may include a switch connected to the ignition switch in a cascode manner and configured to be turned on in response to an input of a diagnosis signal, and a resistor connected to a connection node to which the ignition switch and the switch are connected, and when the switch is turned on, the diagnosis current may be configured to flow along a current path connected to the fuse element, the switch, the first resistor, and a ground node.

The diagnosis current may be a constant current having a magnitude that is determined by a resistance value of the resistor.

When both the ignition switch and the first switch are turned on, the ignition current may be configured to flow along a current path connected to the fuse element, the switch, the ignition switch, and the ground node.

The switch may be configured to be turned on in response to an input of at least one of the diagnosis signal and the second ignition signal, and the diagnosis current supply circuit may further include a delay circuit configured to delay a turn-on time of the switch relative to a time when the diagnosis signal or the second ignition signal is input.

The diagnosis current supply circuit may further include a second switch connected to the first switch in a cascade manner and configured to be turned on according to an input of the diagnostic signal or the second ignition signal to turn on the first switch.

The fuse device may further include a driving circuit configured to allow or block a current flow from a first power node to which a first power voltage is applied to the fuse element, and a resistance monitoring circuit configured to monitor a resistance value of an internal resistance of the fuse element based on a voltage at both ends of the fuse element.

When the resistance value of the internal resistance of the fuse element monitored by the resistance monitoring circuit is outside a preset range, the driving circuit may be configured to block the current flow to the fuse element.

The fuse device may further include a switch monitoring circuit including a monitoring resistor connected between a second power node to which a second power voltage is applied and the connection node to monitor an abnormality of the first switch and the ignition switch.

The magnitude of the voltage formed at the connection node may be configured to vary according to whether the first switch and the ignition switch are in a turn-on state or a turn-off state.

A battery management system according to one embodiment of the present invention includes a fuse element configured to block a current path connected to a battery, a diagnosis current supply circuit connected to the fuse element and configured to allow a diagnosis current for diagnosing the fuse element to flow through the fuse element, an ignition circuit connected to the diagnosis current supply circuit and configured to allow an ignition current for ignition of the fuse element to flow through the fuse element, and a processor that is configured to (i) diagnose the fuse element by deactivating the ignition circuit and activating the diagnosis current supply circuit to form the diagnosis current and (ii) ignite the fuse element by activating both the diagnosis current supply circuit and the ignition circuit to form the ignition current.

The ignition circuit may include an ignition switch that is configured to be turned on in response to an input of at least one of first and second ignition signals to form the ignition current in the fuse element, and the diagnosis current supply circuit may include a first switch connected to the ignition switch in a cascode manner and turned on in response to an input of a diagnosis signal, and a first resistor connected to a connection node to which the ignition switch and the first switch are connected.

The battery management system may further include a driving circuit allowing or blocking a current flow from a first power node to which a first power voltage is applied to the fuse element, and a resistance monitoring circuit configured to monitor a resistance value of an internal resistance of the fuse element, wherein the processor may be configured to control the driving circuit to allow a current flow from the first power node to the fuse element when monitoring the resistance value of the internal resistance of the fuse element.

When monitoring the resistance value of the internal resistance of the fuse element, the processor (i) may control the diagnosis current supply circuit to allow the diagnosis current to flow through the fuse element and (ii) may monitor the resistance value of the internal resistance of the fuse element through the resistance monitoring circuit while the diagnosis current is flowing through the fuse element.

The processor may be configured to monitor the resistance value of the internal resistance of the fuse element based on a voltage at both ends of the fuse element and a magnitude of the diagnosis current identified through the resistance monitoring circuit.

The processor may be configured to determine that an abnormality has occurred in the fuse element and blocks a current flow from the first power node to the fuse element through the driving circuit when the resistance value of the internal resistance of the fuse element monitored by the resistance monitoring circuit is outside a preset range.

The processor may be configured to determine whether the fuse element is short-circuited based on a voltage at both ends of the fuse element identified through the resistance monitoring circuit, and when the short-circuit of the fuse element is detected, the processor is configured to control the driving circuit to block a current flow from the first power node to the fuse element.

The battery management system may further include a switch monitoring circuit including a monitoring resistor connected between a second power node to which a second power voltage is applied and the connection node to monitor an abnormality of the first switch and the ignition switch, wherein the processor may be configured to monitor for an abnormality of the first switch and the ignition switch by monitoring a magnitude of a voltage formed at the connection node, wherein the magnitude of the voltage formed at the connection node may be configured to vary according to whether the first switch and the ignition switch are in a turn-on state or a turn-off state.

A battery pack according to one embodiment of the present invention includes a battery, a fuse element configured to block a current path connected to the battery, a diagnosis current supply circuit connected to the fuse element and configured to allow a diagnosis current for diagnosing the fuse element to flow through the fuse element, an ignition circuit connected to the diagnosis current supply circuit and configured to allow an ignition current for ignition of the fuse element to flow through the fuse element, and a processor that is configured to (i) diagnose the fuse element by deactivating the ignition circuit and activating the diagnosis current supply circuit to form the diagnosis current and (ii) ignite the fuse element by activating both the diagnosis current supply circuit and the ignition circuit to form the ignition current.

At least some of the above and other features of the invention are set out in the claims.

### BRIEF DESCRIPTION OF THE DRAWINGS

The drawings attached to this specification illustrate embodiments of the present disclosure, and further describe aspects and features of the present disclosure together with the detailed description of the present disclosure. The present disclosure is not limited to the embodiments depicted in the drawings.
FIG. 1 is a block diagram of a battery management system and a battery pack according to one embodiment of the present disclosure;
FIG. 2 is a block diagram of a fuse device according to one embodiment of the present disclosure;
FIG. 3 is a circuit diagram of the fuse device according to one embodiment of the present disclosure;
FIGS. 4A to 4C are diagrams of an example fuse diagnosis operation of the fuse device according to one embodiment of the present disclosure; and
FIG. 5 is a diagram of an example fuse ignition operation of the fuse device according to one embodiment of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein includes all sub-ranges of the same numerical precision subsumed within the recited range. For example, a range of "1.0 to 10.0" includes all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein includes all lower numerical limitations subsumed therein, and any minimum numerical limitation recited in this specification includes all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. In addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

### 1. Battery management system and Battery pack

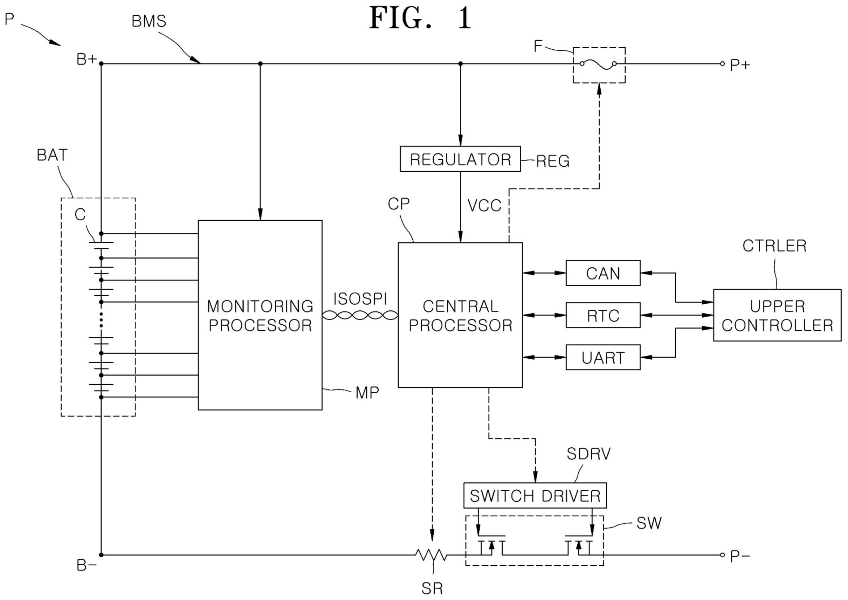

FIG. 1 is a block diagram of a battery management system and a battery pack according to an embodiment of the present disclosure.

Referring to FIG. 1, a battery management system BMS of the present embodiment may include a monitoring processor MP, a central processor CP, a shunt resistor SR, a charge/discharge switch SW, a switch driver SDRV, a regulator REG, and a fuse device F. The BMS may be a part of a battery pack P together with a battery BAT. The battery pack P of the present embodiment may be used as a power supply device of a small electronic device such as a mobile phone, a notebook computer, or a camcorder. In other embodiments, the battery pack P may be used as a power supply device of an industrial device such as an electric vehicle (EV), a hybrid vehicle (HV), or an energy storage system (ESS). Hereinafter, an embodiment in which the battery pack P is applied to an electric vehicle will be described.

The battery BAT may correspond to a battery module (including a structure in which battery modules are connected in series or in parallel) in which battery cells C are connected in series or in parallel. When the battery pack P is applied to an electric vehicle, the battery BAT may be implemented as a high-voltage battery (e.g., a lithium ion battery, a lithium polymer battery, a nickel cadmium battery, a nickel hydrogen battery, a nickel zinc battery, or the like) that supplies a high voltage (e.g., 400V or 800V). The battery BAT may be the main battery that drives a system by supplying power to a load. That is, the battery BAT may be a driving system (e.g., a driving motor and an inverter) of the electric vehicle, and the battery BAT may be charged by a charging current supplied from an external charging device. Separate from the main battery BAT, an auxiliary battery (e.g., a lead-acid battery) (not shown) for supplying low voltage power (e.g., 12V) to an electrical system (e.g., a lamp system, a wiper system, an air conditioning system, etc.) of the electric vehicle may be provided in the battery pack P.

The monitoring processor MP may correspond to an analog front end (AFE) integrated circuit (IC) that monitors a state of each battery cell C and performs a battery cell control operation according to the monitoring results. For example, the monitoring processor MP may be configured to monitor a voltage, a current, a temperature, and a state of charge (SOC) of the battery cell C. Further, the monitoring processor MP may perform control operations such as balancing control, temperature control, and charge/discharge control of the battery cell C or perform protection operations such as control of the charge/discharge switch SW for preventing overdischarging or overcharging according to the monitoring result. The state data of the battery cell C acquired by the monitoring processor MP (that is, the voltage, current, temperature, and SOC of the battery cell C) may be transmitted to the central processor CP through isolated serial peripheral interface (ISOSPI) communication.

The central processor CP may allow the monitoring processor MP to perform the above-described control and protection operations by generating a control operation command or protection operation command according to the state data of the battery cell C transmitted from the monitoring processor MP and feeding the state data back to the monitoring processor MP. The central processor CP performing the functions may correspond to a micro controller unit (MCU) of the BMS. The central processor CP may communicate with an upper controller CTRLER (e.g., an ECU of a vehicle in which the battery pack P is mounted) through a communication protocol such as a controller area network CAN, real time clock RTC, and/or universal asynchronous receiver/transmitter UART (the processor CP and the first processor CP indicated in the claims of the present specification refer to the central processor CP, and a second processor CTRLER refers to the upper controller CTRLER such as an ECU of the vehicle).

The shunt resistor SR is connected on a path (corresponding to a charge/discharge path) from a positive terminal P+ of the battery pack P to a negative terminal P- of the battery pack P through the battery cell C. The shunt resistor SR may function as a resistance element for detecting an overcurrent flowing in the battery cell C.

The charge/discharge switch SW may correspond to a metal oxide semiconductor field-effect transistor (MOSFET) that controls a current flow on the above-described charge/discharge path. The switch driver SDRV may correspond to a gate driver that controls the on/off operation of the charge/discharge switch SW under the control of the central processor CP.

The monitoring processor or the central processor CP may be the structure that detects overcurrent through the shunt resistor SR. The monitoring or central processors may also control the on/off operation of the charge/discharge switch SW by controlling the switch driver SDRV when the overcurrent is detected. FIG. 1 illustrates an example in which the structure that performs these operations corresponds to the central processor CP. And, in this case, the central processor CP may operate to prevent damage to the battery cell C due to the overcurrent by detecting overcurrent flowing to the battery cell C through the shunt resistor SR and controlling the switch driver SDRV to turn off the charge/discharge switch SW.

The regulator REG may regulate a voltage level at an uppermost node B+ of the plurality of battery cells C to a level corresponding to an operating voltage of the central processor CP, and an operating voltage VCC of the central processor CP may be generated by the regulator REG. The regulator REG may be implemented as a direct-current (DC/DC) converter that converts a voltage at the uppermost node B+ of the plurality of battery cells C into the operating voltage of the central processor CP.

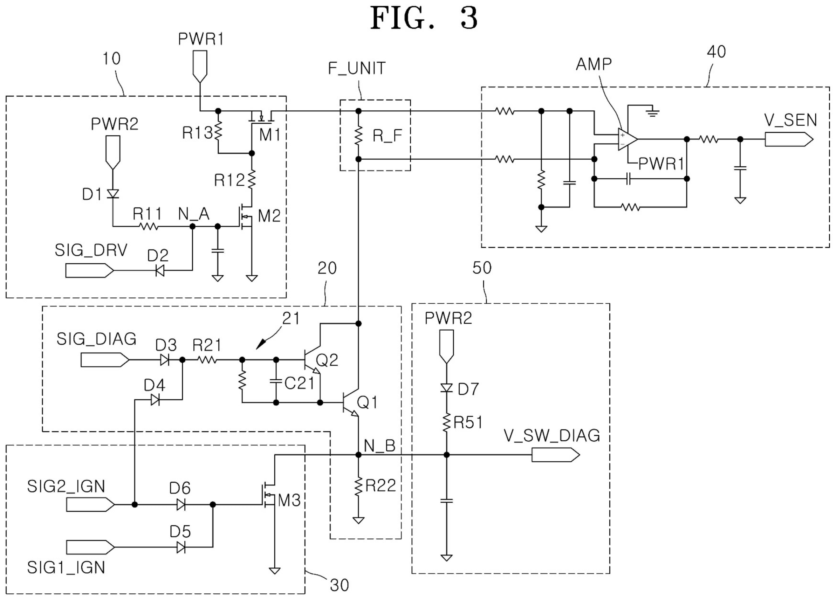

The fuse device F may be configured to block a current path (i.e., the above-described charge/discharge path) connected to the battery BAT. Here, blocking of the current path may refer to a blocking of current flow through physical cutting of the current path. In the present embodiment, the fuse device F includes a fuse element F_UNIT to be ignited and diagnosed and a peripheral circuit thereof (a driving circuit 10, a diagnosis current supply circuit 20, an ignition circuit 30, a resistance monitoring circuit 40, and a switch monitoring circuit 50; see FIG 3), and a detailed description thereof provided below.

When a battery pack is applied to an electric vehicle, a protection function in which the power of the battery pack is shut down when an impact is detected due to a collision accident of the electric vehicle is generally provided. But, in some cases, the protection function may not function properly. When the protection function does not function, a pyrofuse (or pyroswitch) may be provided in the battery pack as the fuse element F_UNIT for blocking the current path connected to the battery. The pyrofuse is a fuse element F_UNIT that explodes when a current having a magnitude greater than or equal to a threshold value defined for ignition thereof flows and physically cuts a wiring disposed adjacent thereto. The fuse element F_UNIT constituting the fuse device F of the present disclosure may be implemented as a pyrofuse.

Hereinafter, the circuit configuration and operation will be described for the fuse device F, which may integrally perform the fuse diagnosis operation and the fuse ignition operation and may diagnose an abnormality in the diagnosis current supply circuit 20 and the ignition circuit 30 applied to the fuse device F in addition to the fuse element F_UNIT.

### 2. Fuse device

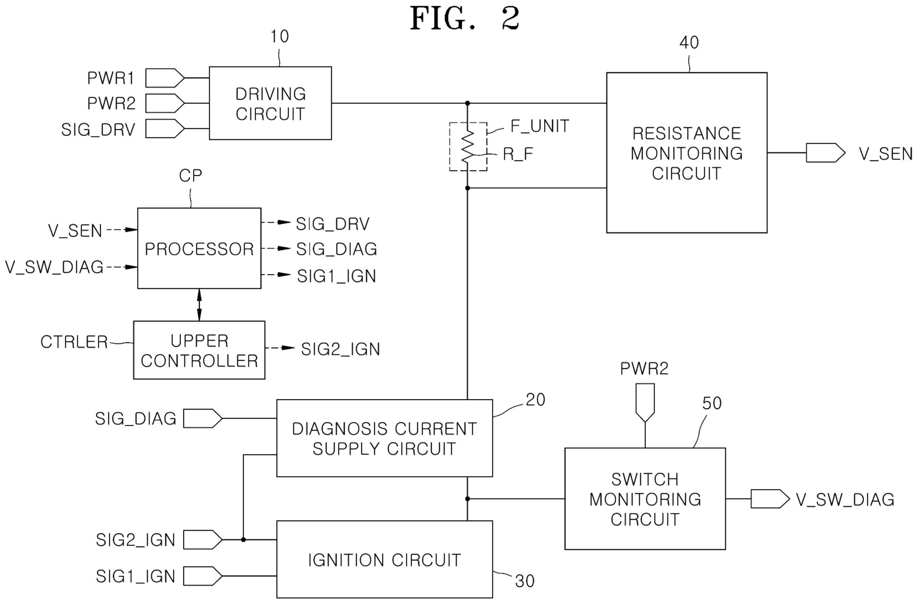

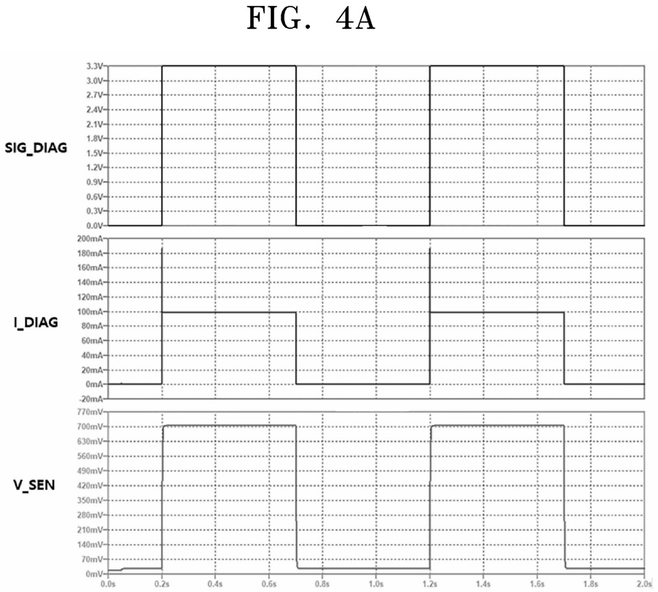

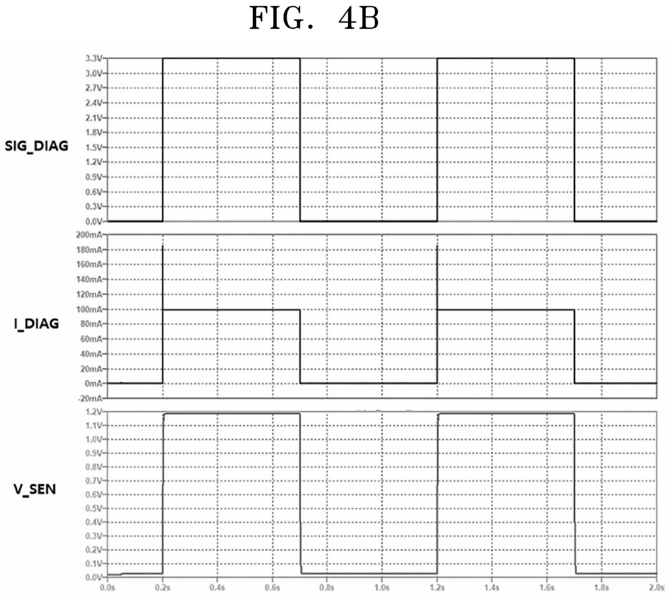

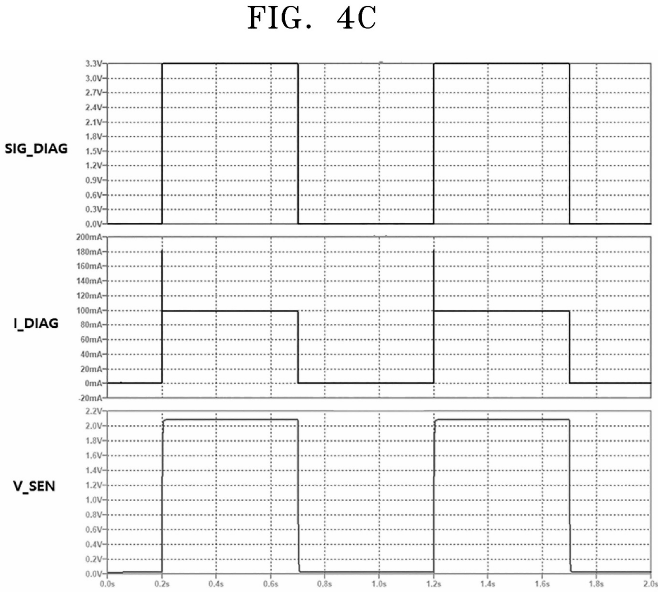

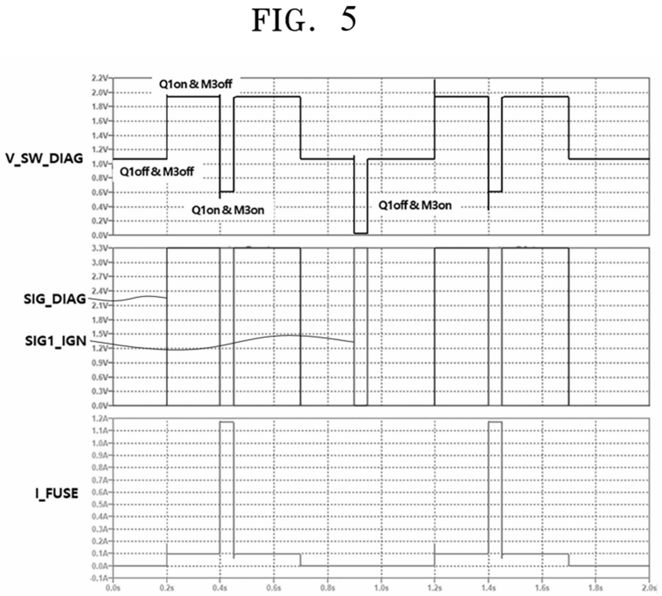

FIG. 2 is a block diagram illustrating a fuse device according to an embodiment of the present disclosure, FIG. 3 is a circuit diagram illustrating the fuse device according to an embodiment of the present disclosure, FIGS. 4A to 4C are diagrams for describing an example fuse diagnosis operation of the fuse device according to an embodiment of the present disclosure, and FIG. 5 is a diagram for describing an example fuse ignition operation of the fuse device according to an embodiment of the present disclosure.

Referring to FIG. 2, the fuse device F according to the present disclosure may include a fuse element F_UNIT, a driving circuit 10, an ignition circuit 30, a diagnosis current supply circuit 20, a resistance monitoring circuit 40, and a switch monitoring circuit 50. In the example depicted in FIG. 2, the fuse element F_UNIT is modeled as an internal resistance R_F. The fuse device F may include a driving signal input node to which a driving signal SIG_DRV for activating the driving circuit 10 is input, first and second ignition signal input nodes to which first and second ignition signals SIG1_IGN and SIG2_IGN for activating the ignition circuit 30 are input, respectively, and a diagnosis signal input node to which a diagnosis signal SIG_DIAG for activating the diagnosis current supply circuit 20 is input, as signal input nodes. In addition, the fuse device F may have a first power node to which a first power voltage PWR1 is input and a second power node to which a second power voltage PWR2 is input, as power input nodes. The first and second power voltages PWR1 and PWR2 may be high voltages supplied from the main battery BAT, low voltages supplied from the auxiliary battery, or separate voltages (e.g., VCC) generated through regulation of the high voltage or the low voltage. In addition, the fuse device F may have a first voltage output node that outputs a voltage V_SEN at both ends (more precisely, an amplification value of the voltage at both ends) of the fuse element F_UNIT, and a second voltage output node that outputs a voltage V_SW_DIAG formed at a connection node N_B (to be described below), as output nodes. The voltage V_SEN at both ends of the fuse element F_UNIT and the voltage V_SW_DIAG of the connection node N_B may be transmitted to the processor CP.

Among the signals input to the fuse device F, the driving signal SIG_DRV, the first ignition signal SIG1_IGN, and the diagnosis signal SIG_DIAG may be sent from the processor CP, and the second ignition signal SIG2_IGN may be sent from the upper controller CTRLER (that is, the ECU of the vehicle). Here, the first ignition signal SIG1_IGN may correspond to a signal transmitted to the fuse device F by the processor CP receiving a fuse ignition command from the upper controller CTRLER when impact to the vehicle is detected, and the second ignition signal SIG2_IGN may correspond to a signal directly transmitted to the fuse device F by the upper controller CTRLER when the impact to the vehicle is detected.

Sub-components of the fuse device F will be described in detail with reference to FIG. 3. In FIG. 3, only elements necessary for describing the operation of the fuse device F are indicated by reference signs, and passive elements not indicated by reference signs refer to wiring impedance applied when a circuit is designed.

The fuse element F_UNIT may be implemented with the above-described pyrofuse. The fuse element F_UNIT may be configured to explode when a current having a magnitude greater than or equal to a threshold value defined for ignition flows to thereby block a current path connected to the battery BAT.

The driving circuit 10 may be configured to allow or block a current flow from the first power node to the fuse element F_UNIT. To this end, the driving circuit 10 may include a main driving switch M1 and a sub driving switch M2.

As an example in which the main driving switch M1 and the sub driving switch M2 are implemented as an FET (N-type), a gate terminal of the sub driving switch M2 is connected to the second power node through a connection resistor R11 and a diode D1, with the diode D1 being connected in a forward direction based on a direction from the second power node to the gate terminal of the sub driving switch M2), and a source terminal is connected to the ground node. A node N_A to which the gate terminal of the sub driving switch M2 and the connection resistor R11 are connected is connected to the driving signal input node through a diode D2, with the diode D2 being connected in a forward direction based on a direction from the node N_A to the driving signal input node. The gate terminal of the main driving switch M1 is connected to a drain terminal of the sub driving switch M2 and the first power node through each of a connection resistor R12 and a connection resistor R13. A source terminal of the main driving switch M1 is connected to the first power node, and a drain terminal thereof is connected to the fuse element F_UNIT.

When the battery pack P is in a wake-up state/ normal state in which the battery pack P normally operates, the processor CP may input a high-level driving signal SIG_DRV to the driving signal input node or maintain the driving signal input node in a floating state, and the driving signal input node is electrically separated from the node N_A by the diode D2. Accordingly, the driving circuit 10 maintains the active state at all times except when the fuse element F_UNIT is abnormal or short-circuited (described below) and the battery pack P is in a shut-down state. The sub driving switch M2 is turned on by the second power voltage PWR2 input from the second power node, whereby current flows from the first power node to the ground node GND through the connection resistors R13 and R12 and the drain terminal and the source terminal of the sub driving switch M2. The flowing current and the voltage signal formed by the connection resistors R13 and R12 are formed at the gate terminal of the main driving switch M1. Accordingly, the main driving switch M1 is turned on so that the current may flow from the first power node to the fuse element F_UNIT. When a ground-level driving signal SIG_DRV is input from the processor CP to the driving signal input node (i.e., when the driving signal input node is grounded), the current from the second power node is discharged through the driving signal input node through the diode D1, the connection resistor R11, and the diode D2, so that the voltage level of the node N_A is reduced and the sub driving switch M2 and the main driving switch M1 are turned off. Thus, the current flow from the first power node to the fuse element F_UNIT is blocked.

Accordingly, the driving circuit 10 may function as a high side switch for driving a current flow to the fuse element F_UNIT by controlling whether the fuse element F_UNIT is electrically conductive. And the magnitude of the current flowing through the fuse element F_UNIT is determined by the diagnosis current supply circuit 20 and the ignition circuit 30.

Next, the diagnosis current supply circuit 20 may be configured to generate a diagnosis current for diagnosing the fuse element F_UNIT. A voltage formed at both ends of the fuse element F_UNIT as the diagnosis current flows through the fuse element F_UNIT may be measured by the resistance monitoring circuit 40 (described below). Accordingly, the processor CP may operate to monitor a resistance value of an internal resistance of the fuse element F_UNIT based on the voltage measured by the resistance monitoring circuit 40.

The diagnosis current supply circuit 20 may include first and second switches Q1 and Q2, a delay circuit 21, and a first resistor R22.

In an example where the first and second switches Q1 and Q2 are implemented as BJTs (NPN), a collector terminal of the first switch Q1 is connected to the fuse element F_UNIT, and an emitter terminal thereof is connected to the ground node through the first resistor R22. A collector terminal of the second switch Q2 is connected to the fuse element F_UNIT and the collector terminal of the first switch Q1, and an emitter terminal thereof is connected to a base terminal of the first switch Q1. Accordingly, the first and second switches Q1 and Q2 are connected in a cascade manner.

The delay circuit 21 is connected between the diagnosis signal input node and a base terminal of the second switch Q2. The delay circuit 21 may include a second resistor R21 and a capacitor C21 constituting an RC filter. The diagnosis signal SIG_DIAG input through the diagnosis signal input node may be configured to be applied to the base terminal of the second switch Q2 through the delay circuit 21. The diagnosis current supply circuit 20 may be configured to receive the second ignition signal SIG2_IGN (described below) together with the diagnosis signal SIG_DIAG. The base terminal of the second switch Q2 is connected to the diagnosis signal input node and the second ignition signal input node through the delay circuit 21 in an 'OR' manner. The 'OR' type connection structure may be implemented as a structure in which diodes D3 and D4 are connected to the diagnosis signal input node and the second ignition signal input node DN, respectively, and cathodes of the diodes D3 and D4 are commonly connected to the base terminal of the second switch Q2 through the delay circuit 21. Accordingly, the second switch Q2 may be turned on in response to an input of at least one of the diagnosis signal SIG_DIAG and the second ignition signal SIG2_IGN. That is, when one or more of the diagnosis signal SIG_DIAG and the second ignition signal SIG2_IGN is at a high level, the second switch Q2 may be turned on.

When a high-level diagnosis signal SIG_DIAG is input through the diagnosis signal input node, the voltage level (high level) of the diagnosis signal SIG_DIAG is formed at the base terminal of the second switch Q2 at a time point that has elapsed by a time corresponding to an RC time constant of the delay circuit 21 from the input time point. As will be described below, the time delay by the delay circuit 21 prevents the first and second switches Q1 and Q2 from being turned on by a temporary noise signal input through the second ignition signal input node, which thereby prevents the fuse element F_UNIT from being ignited and does not affect the diagnosis operation of diagnosing an abnormality of the fuse element F_UNIT by generating the diagnosis current. When the second switch Q2 is turned on, a current flowing from the collector terminal of the second switch Q2 to the emitter terminal is input to the base terminal of the first switch Q1 to turn on the first switch Q1. Accordingly, a diagnosis current flows along a current path connected to the first power node, the fuse element F_UNIT, the first switch Q1, the first resistor R22, and the ground node (assuming a turn-off state of an ignition switch M3, which is described below).

According to the DC analysis of the BJT, the magnitude (i.e., the current value) of the diagnosis current flowing through the fuse element F_UNIT is determined by the magnitude (i.e., the voltage value) of the base terminal voltage of the first switch Q1 and the resistance value of the first resistor R22 (i.e., (the base terminal voltage-the threshold voltage)/the resistance value of the first resistor R22). Assuming that the base terminal voltage has a fixed value according to the design specifications of the fuse device F, the magnitude of the diagnosis current flowing through the fuse element F_UNIT is determined based on the resistance value of the first resistor R22. And since the resistance value of the first resistor R22 has a constant value, the diagnosis current flowing through the fuse element F_UNIT is a constant current. Thus, the diagnosis current supply circuit 20 may function as a constant current supply circuit. The first resistor R22 may have a resistance value designed in advance to limit the diagnosis current so that the fuse element F_UNIT is not ignited by the diagnosis current when the ignition switch M3 is in the turn-off state.

Since the magnitude of the diagnosis current (i.e., constant current) is determined only by the first resistor R22, a variation in the resistance value of the internal resistance of the fuse element F_UNIT or a variation in the first power voltage PWR1 does not affect the magnitude of the diagnosis current. The constant current forming method enables an internal resistance monitoring operation based on a voltage across both ends using the resistance monitoring circuit 40.

The ignition circuit 30 may be configured to generate an ignition current for ignition of the fuse element F_UNIT. As the ignition current formed by the ignition circuit 30 flows through the fuse element F_UNIT, the fuse element F_UNIT may be ignited and the current path connected to the battery BAT may be blocked. The ignition circuit 30 may include an ignition switch M3 as a switch for forming an ignition current, and the ignition switch M3 may be implemented as an FET (N-type).

In the connection structure of the ignition switch M3, a drain terminal of the ignition switch M3 is connected to the emitter terminal of the first switch Q1. Thus, the first switch Q1 and the ignition switch M3 are connected in a cascode manner. For convenience, a node to which the drain terminal of the ignition switch M3, the emitter terminal of the first switch Q1, the first resistor R22, and a monitoring resistor R51 to be described below are connected is referred to as the connection node N_B). A gate terminal of the ignition switch M3 is connected to the first and second ignition signal input nodes in the 'OR' manner. The 'OR' type connection structure may be implemented as a structure in which diodes D5 and D6 are connected to the first and second ignition signal input nodes, respectively, and cathodes of the diodes D5 and D6 are connected to the gate terminal of the ignition switch M3. Accordingly, the ignition switch M3 may be turned on in response to an input of at least one of the first and second ignition signals SIG1_IGN and SIG2_IGN. That is, when the state of one or more of the first and second ignition signals SIG1_IGN and SIG2_IGN is at a high level, the ignition switch M3 may be turned on. From the point of view of connection with the driving circuit 10 described above, the ignition circuit 30 may function as a low side switch that drives the current flow to the fuse element F_UNIT by controlling whether the fuse element F_UNIT is electrically conductive.

When the first switch Q1 of the above-described diagnosis current supply circuit 20 is turned on, and when the ignition switch M3 is turned on, an ignition current having a magnitude greater than or equal to a threshold value may flow along a current path connected to the first power node, the fuse element F_UNIT, the first switch Q1, the ignition switch M3, and the ground node. Thus, the fuse element F_UNIT may be ignited. In this case, as the second switch Q2 operates as a current buffer, a current flowing from the collector terminal of the second switch Q2 to the emitter terminal may be input to the base terminal of the first switch Q1 to turn on the first switch Q1, and a current flowing from the base terminal of the first switch Q1 to the emitter terminal may be formed, so that an ignition current having a magnitude equal to or greater than a threshold value sufficient to ignite the fuse element F_UNIT may be formed. In addition, the magnitude of the first power voltage PWR1 and the resistance value of the internal resistance of the fuse element F_UNIT may be configured as values for forming an ignition current having a magnitude equal to or greater than the threshold value. Since both ends of the first resistor R22 connected in parallel to the ignition switch M3 are short-circuited when the ignition switch M3 is turned on, the ignition current does not flow to the first resistor R22 and only flows to the ignition switch M3.

With the connection structure of the driving circuit 10, the diagnosis current supply circuit 20, and the ignition circuit 30, the diagnosis current supply circuit 20 may form a diagnosis current regardless of whether the ignition circuit 30 is activated. Forming the diagnosis current independent of activation of the ignition circuit 30 provides for a diagnosis current generated by the diagnosis current supply circuit 20 regardless of the turn-on or turn-off of the ignition switch M3. In particular, the diagnosis current may be formed by the diagnosis current supply circuit 20 even when the ignition circuit 30 is in an inactive state (i.e., the turn-off state of the ignition switch M3).

Because the driving circuit 10 maintains an active state except for when the battery pack P is shut down and when the fuse element F_UNIT is abnormal or short-circuited, when the diagnosis current supply circuit 20 is activated in the inactive state of the ignition circuit 30 (that is, when the first and second switches Q1 and Q2 are turned on), the diagnosis current flows along the current path connected to the first power node, the fuse element F_UNIT, the first switch Q1, the first resistor R22, and the ground node. Even when the ignition circuit 30 is activated, a diagnosis current may flow along the current path connected to the first power node, the fuse element F_UNIT, the first switch Q1, the ignition switch M3, and the ground node. In such a case, the diagnosis current constitutes a part of the ignition current, but since the fuse element F_UNIT is ignited by the ignition current, the diagnostic operation of the fuse element F_UNIT is not performed.

Conversely, the ignition circuit 30 may be configured to form an ignition current depending on whether the diagnosis current supply circuit 20 is activated or not. The fact that the ignition current is generated depending on whether the diagnosis current supply circuit 20 is activated means that the ignition current is generated only when the first and second switches Q1 and Q2 are turned on.

Specifically, the driving circuit 10 maintains an active state at all times except when the fuse element F_UNIT is abnormal or short-circuited and the battery pack P is in a shut-down state. When the diagnosis current supply circuit 20 is deactivated (that is, when the first and second switches Q1 and Q2 are turned off), the fuse element F_UNIT is not electrically conductive. Thus, even when the ignition circuit 30 is activated (when the ignition switch M3 connected to the first switch Q1 in the cascode manner is turned on), the ignition current does not flow in the fuse element F_UNIT. When the diagnosis current supply circuit 20 is activated (when the first and second switches Q1 and Q2 are turned on), and when the ignition circuit 30 is activated, the ignition current flows along the current path connected to the first power node, the fuse element F_UNIT, the first switch Q1, the ignition switch M3, and the ground node.

The linked operation of the diagnosis current supply circuit 20 and the ignition circuit 30 are as follows.

When the first and second switches Q1 and Q2 of the diagnosis current supply circuit 20 are turned on in a state in which the sub driving switch M2 and the main driving switch M1 of the driving circuit 10 are turned on, the diagnosis current flows along the current path connected to the first power node, the fuse element F_UNIT, the first switch Q1, the first resistor R22, and the ground node. As described above, the second switch Q2 of the diagnosis current supply circuit 20 operates as a current buffer, but the magnitude of the diagnosis current is limited by the first resistor R22. Thus, the fuse element F_UNIT is not ignited by the diagnosis current.

When the ignition switch M3 is turned on, the ignition current flows through the current path connected to the first power node, the fuse element F_UNIT, the first switch Q1, the ignition switch M3, and the ground node. Since both ends of the first resistor R22 connected in parallel to the ignition switch M3 are short-circuited when the ignition switch M3 is turned on, the current limiting function of the first resistor R22 is eliminated. Thus, the ignition current has a magnitude greater than or equal to a threshold value by the second switch Q2 functioning as a current buffer so that the fuse element F_UNIT may be ignited.

When all the first and second switches Q1 and Q2 and the ignition switch M3 are turned off, and when a high-level second ignition signal SIG2_IGN is input through the second ignition signal input node following an impact to the vehicle, all the first and second switches Q1 and Q2 and the ignition switch M3 are turned on. In this case, the first switch Q1 is turned on later than the ignition switch M3 by the delay circuit 21, that is, there is a time difference between a turn-on time of the first switch Q1 and a turn-on time of the ignition switch M3 by the delay circuit 21. When a vehicle collision occurs, the second ignition signal SIG2_IGN input through the second ignition signal input node is maintained at a high level for a time equal to or greater than the time difference. That is, when there is a vehicle impact, the first switch Q1 is turned on later than the ignition switch M3, but the ignition switch M3 also maintains the turn-on state at the time when the first switch Q1 is turned on. Thus, the ignition current flows through the fuse element F_UNIT so that the fuse element F_UNIT may be ignited as normal.

The second ignition signal SIG2_IGN may be caused by an impact in a vehicle collision. But a noise signal may be generated by an impact such as a door of the vehicle being closed. Even when the second ignition signal SIG2_IGN of the noise signal is input, the first switch Q1 is turned on later than the ignition switch M3 by the delay circuit 21, that is, there is a time difference between the turn-on time of the first switch Q1 and the turn-on time of the ignition switch M3 by the delay circuit 21. At this time, the second ignition signal SIG2_IGN/noise signal is at a high level only during a time less than the time difference. That is, since the second ignition signal SIG2_IGN/noise signal is at the high level only for a very short time, the ignition switch M3 maintains the turn-off state when the first switch Q1 is turned on. Thus, when the second ignition signal SIG2_IGN/noise signal is input, the delay circuit 21 prevents the first switch Q1 and the ignition switch M3 from being turned on, thereby preventing the fuse element F_UNIT from being erroneously ignited. The RC time constant of the delay circuit 21 for implementing the above-described operation may be designed in advance based on the experimental results.

The resistance monitoring circuit 40 may be connected to the fuse element F_UNIT to monitor the resistance value of the internal resistance of the fuse element F_UNIT. The resistance monitoring circuit 40 may include an amplifier AMP that amplifies the voltage V_SEN at both ends of the fuse element F_UNIT. An output terminal of the amplifier AMP is connected to the voltage output node, and the amplifier AMP may be implemented as an OP-AMP.

The resistance monitoring circuit 40 may operate in conjunction with the diagnosis current supply circuit 20. That is, the resistance monitoring circuit 40 may measure the voltage V_SEN at both ends of the fuse element F_UNIT when the diagnosis current generated by the diagnosis current supply circuit 20 flows through the fuse element F_UNIT.

As described above, because the diagnosis current is a constant current, a change in the voltage V_SEN at both ends of the fuse element F_UNIT depends only on a change in the resistance value of the internal resistance of the fuse element F_UNIT. Thus, the processor CP may calculate the resistance value of the internal resistance of the fuse element F_UNIT from the voltage V_SEN at both ends of the fuse element F_UNIT and the magnitude of the diagnosis current (that is, the magnitude of the constant current which may be predefined in the processor CP). And the processor CP may determine that an abnormality has occurred in the fuse element F_UNIT when the calculated resistance value is outside a preset reference range. The reference range corresponds to resistance values capable of determining that an abnormality or deterioration has not occurred in the fuse element F_UNIT. The reference range may be predefined in the processor CP based on intent and experimental results.

FIGS. 4A to 4C show the magnitude of the diagnosis current formed according to the resistance value of the internal resistance of the fuse element F_UNIT and the magnitude of the voltage at both ends of the internal resistance. The magnitudes of the diagnosis current are summarized in Table 1 below (where the numerical values are approximate). In FIGS. 4A to 4C, SIG_DIAG refers to a diagnosis signal, I_DIAG refers to a diagnosis current, and V_SEN refers to the voltage at both ends of the fuse element F_UNIT.

**Table 1**

| | SIG_DIAG @ High level[V] | I_DIAG[mA] | V_SEN[V] |
|---|---|---|---|
| [FIG. 4A] R_F = 1Ω | 3.3V | 100 | 0.7 |
| [FIG. 4B] R_F = 1.7Ω | 3.3V | 100 | 1.2 |
| [FIG. 4C] R_F = 3Ω | 3.3V | 100 | 2.1 |

As shown in FIGS. 4A to 4C and Table 1, even when the resistance value of the internal resistance of the fuse element F_UNIT is changed, the magnitude of the diagnosis current (static current) is constantly maintained at 100 mA. In addition, since the magnitude of the diagnosis current is kept constant, it may be seen that a change in the resistance value of the internal resistance of the fuse element F_UNIT is represented by a change in the voltage V_SEN at both ends of the fuse element F_UNIT. For example, referring to FIGS. 4A to 4C, when the resistance value of the internal resistance of the fuse element F_UNIT increases to 1Ω, 1.7Ω, and 3Ω, the voltage V_SEN at both ends of the fuse element F_UNIT increases to 0.7V, 1.2V, and 2.1V, respectively. That is, as the diagnosis current is formed as a constant current, the abnormality of the fuse element F_UNIT may be easily detected by an operation of measuring only the voltage V_SEN at both ends of the fuse element F_UNIT.

Next, the switch monitoring circuit 50 may function as a circuit for monitoring the abnormality or deterioration of the first switch Q1 and the ignition switch M3. To this end, the switch monitoring circuit 50 may include the monitoring resistor R51 connected between the second power node and the connection node N_B. The monitoring resistor R51 may be connected to the second power node through the diode D7.

The magnitude of the voltage V_SW_DIAG formed at the connection node N_B may be configured to vary according to whether the first switch Q1 and the ignition switch M3 are in a turn-on state or a turn-off state. FIG. 5 and Table 2 below illustrate an example of the voltage V_SW_DIAG formed at the connection node N_B according to the turn-on state or the turn-off state of each switch when both the first switch Q1 and the ignition switch M3 are normal (that is, when deterioration of each switch has not occurred). In FIG. 5, V_SW_DIAG refers to a voltage of the connection node N_B, SIG_DIAG and SIG1_IGN refer to a diagnosis signal and a first ignition signal, respectively, and I_FUSE refers to a current flowing through the fuse element F_UNIT.

**Table 2**

| | Status of Q1 and M3 | I_FUSE[A] | V_SW_DIAG[V] |
|---|---|---|---|
| SIG_DIAG : L | Q1 off & M3 off | 0 | 1.1 |
| SIG1_IGN : L | | | |
| SIG_DIAG : H | Q1 on & M3 off | 0.1 (Diagnosis current) | 2 |
| SIG1_IGN : L | | | |
| SIG_DIAG : H | Q1 on & M3 on | 1.2(Ignition current) | 0.6 |
| SIG1_IGN : H | | | |
| SIG_DIAG : L | Q1 off & M3 on | 0 | 0 |
| SIG1_IGN : H | | | |

When both of the first switch Q1 and the ignition switch M3 are turned off, a current flows through a current path connected to the second power node, the diode D7, the monitoring resistor R51, the first resistor R22, and the ground node. Accordingly, a voltage of 1.1V is formed in the connection node N_B by voltage division by the monitoring resistor R51 and the first resistor R22.

When the first switch Q1 and the ignition switch M3 are turned on and off, respectively, a diagnosis current of 0.1 A flows along a current path connected to the first power node, the fuse element F_UNIT, the first switch Q1, the first resistor R22, and the ground node. And a voltage of 2 V is formed at the connection node N_B by the diagnosis current and the first resistor R22.

When both the first switch Q1 and the ignition switch M3 are turned on, since the fuse element F_UNIT is ignited, abnormal monitoring operations of the first switch Q1 and the ignition switch M3 are not performed. In this regard, Table 2 shows a value obtained by analyzing the circuit operation.

When the first switch Q1 and the ignition switch M3 are turned off and turned on, respectively, the connection node N_B is connected to the ground node through the ignition switch M3 to form a voltage of 0 V.

The processor CP may monitor the abnormality of the first switch Q1 and the ignition switch M3 by monitoring the magnitude of the voltage formed at the connection node N_B. A detailed description will be provided below.

### 3. Fuse device control operation by BMS

Hereinafter, based on the above-described circuit structure of the fuse device F, an operation of diagnosing an abnormality of the fuse element F_UNIT, an operation of igniting the fuse element F_UNIT, and an operation of diagnosing an abnormality of the first switch Q1 and the ignition switch M3 will be described in detail with respect to the processor CP of the battery management system BMS.

When performing the fuse diagnosis operation, the processor CP may input a high-level driving signal SIG_DRV to the driving signal input node or maintain the driving signal input node in a floating state to activate the driving circuit 10. Accordingly, the sub driving switch M2 and the main driving switch M1 are sequentially turned on so that the current may flow from the first power node to the fuse element F_UNIT. At the same time, the processor CP may deactivate the ignition circuit 30 by inputting a low-level first ignition signal SIG1 IGN to the first ignition signal input node, and the processor CP may activate the diagnosis current supply circuit 20 by inputting a high-level diagnosis signal SIG_DIAG to the diagnosis signal input node. Thus, the first and second switches Q1 and Q2 are turned on so that the diagnosis current flows along the current path connected to the first power node, the fuse element F_UNIT, the first switch Q1 , the first resistor R22, and the ground node.

As described above, the diagnosis current flowing in the fuse element F_UNIT is a constant current having a predefined magnitude according to the resistance value of the first resistor R22. Since the magnitude of the diagnosis current (i.e., constant current) is determined only by the first resistor R22, the variation in the resistance value of the internal resistance of the fuse element F_UNIT does not affect the magnitude of the diagnosis current. The magnitude of the constant current flowing through the fuse element F_UNIT may be predefined in the processor CP.

When the diagnosis current flows in the fuse element F_UNIT, the processor CP may monitor the resistance value of the internal resistance of the fuse element F_UNIT through the resistance monitoring circuit 40. Specifically, the processor CP may monitor the resistance value of the internal resistance of the fuse element F_UNIT by calculating the resistance value of the internal resistance of the fuse element F_UNIT based on the magnitude of the diagnosis current (constant current) and the voltage V_SEN at both ends of the fuse element F_UNIT identified through the resistance monitoring circuit 40.

When the resistance value of the internal resistance of the fuse element F_UNIT is outside a preset reference range, the processor CP may determine that an abnormality has occurred in the fuse element F_UNIT. The reference range corresponds to resistance values capable of determining that an abnormality or deterioration does not occur in the fuse element F_UNIT. The reference range may be predefined in the processor CP based on intent and experimental results.

When it is determined that an abnormality occurs in the fuse element F_UNIT, the processor CP may control the driving circuit 10 to block the current flow from the first power node to the fuse element F_UNIT. That is, the processor CP may deactivate the driving circuit 10 by inputting a low-level driving signal SIG_DRV to the driving signal input node (i.e., by grounding the driving signal input node). Thus, additional damage to the fuse element F_UNIT, which otherwise may be caused by the continuous application of current from the first power node to the fuse element F_UNIT even though an abnormality occurs in the fuse element F_UNIT, may be prevented.

In addition, the processor CP may determine whether the fuse element F_UNIT is short-circuited based on the voltage V_SEN at both ends of the fuse element F_UNIT identified through the resistance monitoring circuit 40. When a short-circuit of the fuse element F_UNIT is detected, control the driving circuit 10 to block the current flow from the first power node to the fuse element F_UNIT. That is, the processor CP may determine that both ends of the fuse element F_UNIT are short-circuited when the voltage V_SEN at both ends of the fuse element F_UNIT identified through the resistance monitoring circuit 40 has a value of 0, and the processor CP may input a low-level driving signal SIG_DRV to the driving signal input node to deactivate the driving circuit 10 when the short-circuit of the fuse element F_UNIT is detected. Accordingly, damage to the fuse device F, which otherwise may be caused by the continuous flow of current through the short circuit, may be prevented.

When performing the fuse ignition operation, the processor CP may input a high-level driving signal SIG_DRV to the driving signal input node or maintain the driving signal input node in a floating state to activate the driving circuit 10. Accordingly, the sub driving switch M2 and the main driving switch M1 are sequentially turned on so that the current may flow from the first power node to the fuse element F_UNIT. At the same time, the processor CP may activate the ignition circuit 30 by inputting a high-level first ignition signal SIG1 IGN to the first ignition signal input node, and the processor CP may activate the diagnosis current supply circuit 20 by inputting a high-level diagnosis signal SIG_DIAG to the diagnosis signal input node. Accordingly, the ignition current may flow along the current path connected to the first power node, the fuse element F_UNIT, the first switch Q1, the ignition switch M3, and the ground node. Thus, the fuse element F_UNIT may be ignited. The above-described fuse ignition operation is performed in the same manner even when a high-level second ignition signal SIG2_IGN (excluding a noise signal) is input from the upper controller CTRLER to the second ignition signal input node.

Independent of the above-described fuse diagnosis operation and fuse ignition operation, the processor CP may monitor the abnormality of the first switch Q1 and the ignition switch M3 by monitoring the magnitude of the voltage V_SW_DIAG formed at the connection node N_B (i.e., the node to which the emitter terminal of the first switch Q1, the drain terminal of the ignition switch M3, the first resistor R22 and the monitoring resistor R51 are commonly connected). As described above, the magnitude of the voltage V_SW_DIAG formed at the connection node N_B may vary according to whether the first switch Q1 and the ignition switch M3 are in a turn-on state or a turn-off state.

Accordingly, the processor CP may obtain the voltage V_SW_DIAG formed at the connection node N_B through the second voltage output node in each case where i) both the first switch Q1 and the ignition switch M3 are both turned off, ii) the first switch Q1 and the ignition switch M3 are respectively turned on and off, and iii) the first switch Q1 and the ignition switch M3 are respectively turned off and on. And, when the obtained voltage is different from the predefined reference voltage as shown in Table 2, it may be determined that an abnormality has occurred in at least one of the first switch Q1 and the ignition switch M3.

As described above, according to the present disclosure, a diagnosis and ignition mechanism may be provided to perform a fuse diagnosis operation of monitoring the internal resistance of the fuse element by measuring the voltage V_SEN at both ends of the fuse element in a state in which a diagnosis current (constant current) for diagnosing the fuse element flows through the fuse element, and the mechanism may perform a fuse ignition operation of igniting the fuse element by allowing an ignition current for ignition of the fuse element to flow through the fuse element.

In addition, according to the present disclosure, a circuit topology capable of diagnosing an abnormality for a diagnosis current supply circuit and an ignition circuit required for diagnosing and igniting a fuse element may be provided.

The implementation described in the specification may be implemented, for example, as a method or process, device, a software program, a data stream, or a signal. Even if described only in the context of the implementation of a single form (e.g., only a method is described), the implementations of the described features may also be implemented in other forms (e.g., a device or a program). The device may be implemented with appropriate hardware, software, firmware, or the like. The method may be implemented by a device such as a processor, which is generally a processing device including a computer, a microprocessor, an integrated circuit, or a programmable logic device. The processor may include a communication device such as a computer, a cell phone, a portable/personal digital assistant (PDA), and other devices, which facilitate information communication between end-users.

Effects that can be achieved through the present disclosure are not limited to the above-described effects and other effects that are not described may be clearly understood by those skilled in the art from the detailed descriptions.

Embodiments are set out in the following clauses:
Clause 1. A fuse device comprising: a fuse element configured to block a current path connected to a battery; a diagnosis current supply circuit connected to the fuse element and configured to allow a diagnosis current for diagnosing the fuse element to flow through the fuse element; and an ignition circuit connected to the diagnosis current supply circuit and configured to allow an ignition current for ignition of the fuse element to flow through the fuse element, wherein the diagnosis current supply circuit is configured to form the diagnosis current regardless of whether the ignition circuit is activated, and the ignition circuit is configured to form the ignition current depending on whether the diagnosis current supply circuit is activated.
Clause 2. The fuse device of Clause 1, wherein the ignition circuit includes an ignition switch that is configured to be turned on in response to an input of at least one of first and second ignition signals to form the ignition current in the fuse element, and wherein a first processor is configured to apply the first ignition to control operation of the fuse device and a second processor is configured to apply the second ignition signal, with the second processor functioning as an upper controller of the first processor.
Clause 3. The fuse device of Clause 2, wherein the diagnosis current supply circuit includes a switch connected to the ignition switch in a cascode manner and configured to be turned on in response to an input of a diagnosis signal, and a resistor connected to a connection node to which the ignition switch and the switch are connected, and when the switch is turned on, the diagnosis current is configured to flow along a current path connected to the fuse element, the switch, the resistor, and a ground node.
Clause 4. The fuse device of Clause 3, wherein the diagnosis current is a constant current having a magnitude that is determined by a resistance value of the resistor.
Clause 5. The fuse device of Clause 3 or 4, wherein, when both the ignition switch and the first switch are turned on, the ignition current is configured to flow along a current path connected to the fuse element, the switch, the ignition switch, and the ground node.
Clause 6. The fuse device of Clause 3, 4 or 5, wherein the switch is configured to be turned on in response to an input of at least one of the diagnosis signal and the second ignition signal, and wherein the diagnosis current supply circuit further includes a delay circuit configured to delay a turn-on time of the switch relative to a time when the diagnosis signal or the second ignition signal is input.
Clause 7. The fuse device of Clause 6, wherein the switch is a first switch, and wherein the diagnosis current supply circuit further includes a second switch connected to the first switch in a cascade manner and configured to be turned on according to an input of the diagnostic signal or the second ignition signal to turn on the first switch.
Clause 8. The fuse device of any preceding Clause, further comprising: a driving circuit configured to allow or block a current flow from a power node to which a power voltage is applied to the fuse element; and a resistance monitoring circuit configured to monitor a resistance value of an internal resistance of the fuse element based on a voltage at both ends of the fuse element.
Clause 9. The fuse device of Clause 8, wherein, when the resistance value of the internal resistance of the fuse element monitored by the resistance monitoring circuit is outside a preset range, the driving circuit is configured to block the current flow to the fuse element.
Clause 10. The fuse device of any one of Clauses 3 to 9, further comprising a switch monitoring circuit including a monitoring resistor connected between a power node to which a power voltage is applied and the connection node to monitor an abnormality of the switch and the ignition switch, wherein a magnitude of the voltage formed at the connection node is configured to vary according to whether the switch and the ignition switch are in a turn-on state or a turn-off state.
Clause 11. A battery management system comprising: a fuse element configured to block a current path connected to a battery; a diagnosis current supply circuit connected to the fuse element and configured to allow a diagnosis current for diagnosing the fuse element to flow through the fuse element; an ignition circuit connected to the diagnosis current supply circuit and configured to allow an ignition current for ignition of the fuse element to flow through the fuse element; and a processor that is configured to (i) diagnose the fuse element by deactivating the ignition circuit and activating the diagnosis current supply circuit to form the diagnosis current and (ii) ignite the fuse element by activating both the diagnosis current supply circuit and the ignition circuit to form the ignition current.
Clause 12. The battery management system of Clause 11, wherein the ignition circuit includes an ignition switch that is configured to be turned on in response to an input of at least one of first and second ignition signals to form the ignition current in the fuse element, and the diagnosis current supply circuit includes a switch connected to the ignition switch in a cascode manner and configured to be turned on in response to an input of a diagnosis signal, and a resistor connected to a connection node to which the ignition switch and the switch are connected.
Clause 13. The battery management system of Clause 11 or 12, further comprising: a driving circuit configured to allow or block a current flow from a power node to which a power voltage is applied to the fuse element; and a resistance monitoring circuit configured to monitor a resistance value of an internal resistance of the fuse element, wherein the processor is configured to control the driving circuit to allow a current flow from the power node to the fuse element when monitoring the resistance value of the internal resistance of the fuse element.
Clause 14. The battery management system of Clause 13, wherein, when monitoring the resistance value of the internal resistance of the fuse element, the processor (i) controls the diagnosis current supply circuit to allow the diagnosis current to flow through the fuse element and (ii) monitors the resistance value of the internal resistance of the fuse element through the resistance monitoring circuit while the diagnosis current is flowing through the fuse element.
Clause 15. The battery management system of Clause 14, wherein the processor is configured to: monitor the resistance value of the internal resistance of the fuse element based on a voltage at both ends of the fuse element and a magnitude of the diagnosis current identified through the resistance monitoring circuit, determine that an abnormality has occurred in the fuse element and block a current flow from the power node to the fuse element through the driving circuit when the resistance value of the internal resistance of the fuse element monitored by the resistance monitoring circuit is outside a preset range, and determine whether the fuse element is short-circuited based on a voltage at both ends of the fuse element identified through the resistance monitoring circuit, and when the short-circuit of the fuse element is detected, the processor is configured to control the driving circuit to block a current flow from the power node to the fuse element.

Although the present disclosure has been described with reference to embodiments and drawings illustrating aspects thereof, the present disclosure is not limited thereto. Various modifications and variations can be made by a person skilled in the art to which the present disclosure belongs within the scope of the present disclosure.

## Claims

1. A fuse device comprising:
a fuse element configured to block a current path connected to a battery;
a diagnosis current supply circuit connected to the fuse element and configured to allow a diagnosis current for diagnosing the fuse element to flow through the fuse element; and
an ignition circuit connected to the diagnosis current supply circuit and configured to allow an ignition current for ignition of the fuse element to flow through the fuse element,
wherein the diagnosis current supply circuit is configured to form the diagnosis current regardless of whether the ignition circuit is activated, and the ignition circuit is configured to form the ignition current depending on whether the diagnosis current supply circuit is activated.

2. The fuse device of claim 1, wherein the ignition circuit includes an ignition switch that is configured to be turned on in response to an input of at least one of first and second ignition signals to form the ignition current in the fuse element, and
wherein a first processor is configured to apply the first ignition signal to control operation of the fuse device and a second processor is configured to apply the second ignition signal, with the second processor functioning as an upper controller of the first processor.

3. The fuse device of claim 2, wherein the diagnosis current supply circuit includes a switch connected to the ignition switch in a cascode manner and configured to be turned on in response to an input of a diagnosis signal, and a resistor connected to a connection node to which the ignition switch and the switch are connected, and
when the switch is turned on, the diagnosis current is configured to flow along a current path connected to the fuse element, the switch, the resistor, and a ground node.

4. The fuse device of claim 3, wherein the diagnosis current is a constant current having a magnitude that is determined by a resistance value of the resistor.

5. The fuse device of claim 3 or 4, wherein, when both the ignition switch and the first switch are turned on, the ignition current is configured to flow along a current path connected to the fuse element, the switch, the ignition switch, and the ground node.

6. The fuse device of claim 3, 4 or 5, wherein the switch is configured to be turned on in response to an input of at least one of the diagnosis signal and the second ignition signal, and
wherein the diagnosis current supply circuit further includes a delay circuit configured to delay a turn-on time of the switch relative to a time when the diagnosis signal or the second ignition signal is input.

7. The fuse device of claim 6, wherein the switch is a first switch, and
wherein the diagnosis current supply circuit further includes a second switch connected to the first switch in a cascade manner and configured to be turned on according to an input of the diagnostic signal or the second ignition signal to turn on the first switch.

8. The fuse device of any preceding claim, further comprising:
a driving circuit configured to allow or block a current flow from a power node to which a power voltage is applied to the fuse element; and
a resistance monitoring circuit configured to monitor a resistance value of an internal resistance of the fuse element based on a voltage at both ends of the fuse element.

9. The fuse device of claim 8, wherein, when the resistance value of the internal resistance of the fuse element monitored by the resistance monitoring circuit is outside a preset range, the driving circuit is configured to block the current flow to the fuse element.

10. The fuse device of any one of claims 3 to 9, further comprising a switch monitoring circuit including a monitoring resistor connected between a power node to which a power voltage is applied and the connection node to monitor an abnormality of the switch and the ignition switch,
wherein a magnitude of the voltage formed at the connection node is configured to vary according to whether the switch and the ignition switch are in a turn-on state or a turn-off state.

11. A battery management system comprising:
the fuse device of claim 1; and
a processor that is configured to (i) diagnose the fuse element by deactivating the ignition circuit and activating the diagnosis current supply circuit to form the diagnosis current and (ii) ignite the fuse element by activating both the diagnosis current supply circuit and the ignition circuit to form the ignition current.

12. The battery management system of claim 11, wherein the ignition circuit includes an ignition switch that is configured to be turned on in response to an input of at least one of first and second ignition signals to form the ignition current in the fuse element, and
the diagnosis current supply circuit includes a switch connected to the ignition switch in a cascode manner and configured to be turned on in response to an input of a diagnosis signal, and a resistor connected to a connection node to which the ignition switch and the switch are connected.

13. The battery management system of claim 11 or 12, further comprising:
a driving circuit configured to allow or block a current flow from a power node to which a power voltage is applied to the fuse element; and
a resistance monitoring circuit configured to monitor a resistance value of an internal resistance of the fuse element,
wherein the processor is configured to control the driving circuit to allow a current flow from the power node to the fuse element when monitoring the resistance value of the internal resistance of the fuse element.

14. The battery management system of claim 13, wherein, when monitoring the resistance value of the internal resistance of the fuse element, the processor (i) controls the diagnosis current supply circuit to allow the diagnosis current to flow through the fuse element and (ii) monitors the resistance value of the internal resistance of the fuse element through the resistance monitoring circuit while the diagnosis current is flowing through the fuse element.

15. The battery management system of claim 14, wherein the processor is configured to:
monitor the resistance value of the internal resistance of the fuse element based on a voltage at both ends of the fuse element identified through the resistance monitoring circuit and a magnitude of the diagnosis current,
determine that an abnormality has occurred in the fuse element and block a current flow from the power node to the fuse element through the driving circuit when the resistance value of the internal resistance of the fuse element monitored by the resistance monitoring circuit is outside a preset range, and
determine whether the fuse element is short-circuited based on a voltage at both ends of the fuse element identified through the resistance monitoring circuit, and when the short-circuit of the fuse element is detected, the processor is configured to control the driving circuit to block a current flow from the power node to the fuse element.
